# EUROPÄISCHE PATENTSCHRIFT

(11) **EP 0 489 730 B1**
(45) Veröffentlichungstag und Bekanntmachung des Hinweises auf die Patenterteilung: **18.05.1994**
(21) Anmeldenummer: 90901542.2
(22) Anmeldetag: 16.01.1990
(51) Int. Cl.: G06F 15/80, G11C 7/00, G06E 3/00

(54) **NEURONALES NETZWERK MIT OPTISCHER PROGRAMMIERUNG IN DÜNNFILMTECHNOLOGIE**
THIN-FILM NEURON NETWORK WITH OPTICAL PROGRAMMING
RESEAU NEURONIQUE A PROGRAMMATION OPTIQUE REALISE SELON UNE TECHNIQUE EN COUCHE MINCE

(30) Priorität: 01.09.1989 DE 3929132
(43) Veröffentlichungstag der Anmeldung: 17.06.1992
(73) Patentinhaber: SIEMENS AKTIENGESELLSCHAFT, 80333 München (DE)
(72) Erfinder: ROSAN, Karlheinz, D-8000 München 2 (DE)
(86) Internationale Anmeldenummer: DE9000021
(87) Internationale Veröffentlichungsnummer: WO9103798

(56) Entgegenhaltungen:
- WO-A-86/01931
- DE-A- 3 506 411
- IEEE INTERNATIONAL CONFERENCE ON NEURAL NETWORKS,San Diego,Ca 24-27 July 1988, IEEE, San Diego,US; C.D. KORNFELD et al.: "An optically programmed neural network",

## Beschreibung

Die Erfindung betrifft ein neuronales Netzwerk mit optischer Programmierung in Dünnfilmtechnologie.

Herkömmliche von-Neumann-Rechenmaschinen arbeiten nach einer Rechenvorschrift, die mit Hilfe eines Programms vorgegeben ist. Voraussetzung für die Lösung eines Problems mit einem von-Neumann-Rechner ist daher, daß der Lösungsweg prinzipiell bekannt ist. Nur für einen prinzipiell bekannten Lösungsweg kann nämlich ein Algorithmus aufgestellt werden, der in ein Programm umgesetzt wird.

Es gibt eine Reihe von Problemen, für die die Angabe eines exakten prinzipiellen Lösungsweges nicht möglich ist. Z. B. beim Vergleich einer Unterschrift mit einer abgespeicherten Unterschriftsprobe muß eine Übereinstimmung auch dann erkannt werden, wenn die beiden Unterschriften geringfügig differieren. Bei solchen Problemen der Erkennung unvollständiger Muster stößt ein Von-Neumann-Rechner mit herkömmtlicher Programmierung an die Grenzen seiner Leistungsfähigkeit.

Probleme dieser Art können hingegen mit neuronalen Netzwerken, auch Neuro-Computing genannt, gelöst werden. Neuronale Netzwerke funktionieren nach dem gleichen Prinzip wie das menschliche Gehirn. Ein neuronales Netzwerk besteht aus einer Vielzahl von Neuronen, die jeweils viele Eingänge und einen Ausgang aufweisen. Die Neuronen sind über unterschiedlich starke Verbindungen, die Synapsen genannt werden, miteinander verbunden. In dem Neuron wird nun die gewichtete Summe aller Eingaben gebildet. Aus dieser gewichteten Summe wird über einen Bewerter, der Bestandteil des Neurons ist, ein Ausgangssignal erzeugt. Die Wichtung der einzelnen Eingaben erfolgt über die Synapsen, die unterschiedlich starken Verbindungen. In dem Bewerter wird die Summe entsprechend einer vorgegebenen Funktion bewertet. Als Funktionen kommen dabei z. B. Sprungfunktionen, Schwellenfunktionen oder die Sigmoidfunktion in Frage. Neuronale Netzwerke sind z. B. in J.J. Hopfield, IEEE Circuits and Devices Magazine, September 1988, S. 3 - 10, und Design & Elektronik, Ausgabe 20 vom 27.09.1988, S. 94, 96, 100 - 102, 104, 109 - 117, beschrieben.

Die Information in einem neuronalen Netz ist in der Stärke der Synapsen gespeichert. Die Stärke der Synapsen wird zunächst mit Hilfe von Problembeispielen mit bekannter Lösung, die auf dem neuronalen Netzwerk ablaufen, festgelegt. Im Betrieb eines neuronalen Netzwerkes werden die Synapsen mit Hilfe gefundener Lösungen von bearbeiteten Problemen angepaßt. Dieser Vorgang entspricht dem Abspeichern von Erfahrungen im menschlichen Gehirn. D. h., ein neuronales Netzwerk "lernt ständig dazu".

Damit ein neuronales Netzwerk annähernd die Leistungsfähigkeit des menschlichen Gehirns haben kann, muß die entsprechende Anzahl von Neuronen realisiert werden. Die Oberfläche des menschlichen Gehirns beträgt etwa einen halben Quadratmeter Fläche. Dieser große Flächenbedarf für ein leistungsfähiges neuronales Netzwerk ist der Grund dafür, daß die hardwaremäßige Realisierung noch in den Kinderschuhen steckt, obgleich z. B. in der Mikroelektronik eine leistungsfähige und ausgereifte Technologie zu sehen ist. Neuronale Netzwerke werden daher bislang hauptsächlich auf Computer simuliert.

Bei der hardwaremäßigen Realisierung besteht ein Hauptproblem in der Darstellung der Synapsen. Für die Synapsen werden im Prinzip programmierbare Widerstände benötigt, die einfach aufgebaut sind und die wenig Leistung aufnehmen, da sie in sehr großer Zahl benötigt werden.

Die hardwaremäßige Realisierung eines neuronalen Netzwerkes in amorphem, wasserstoffhaltigem Silizium (a-Si:H) erscheint vielversprechend, da amorphes, wasserstoffhaltiges Silizium eine Reihe von Eigenschaften bietet, die für die Realisierung von neuronalen Netzen besonders vorteilhaft sind. Die Maximalgröße einer Schichtfläche in a-Si:H-Technologie hängt im wesentlichen nur von der Größe des verwendeten Reaktors zur Herstellung der a-Si: H-Schichten ab. Es ist daher durchaus denkbar, einen halben Quadratmeter Fläche, entsprechend der Oberfläche des menschlichen Gehirns, zu erzeugen. Die für ein neuronales Netz benötigten Bauelemente, wie Widerstände, Dioden, Transistoren, sind bei dieser Technologie einfach aufgebaut und erfordern daher nur eine geringe Zahl von Prozeßschritten. Dieses ist wesentlich für die Ausbeute bei der Herstellung großer, leistungsfähiger Netze. Die Bauelemente in a-Si: H-Technologie sind zudem hochohmig und nehmen entsprechend wenig Leistung auf. Der ON-Widerstand von Dünnfilmtransistoren liegt z. B. im Megaohmbereich.

Die a-Si:H-Technologie ist eine Dünnfilmteohnologie. Dünnfilmtechnologien sind von Haus aus Mehrlagentechnologien. Es ist daher möglich mehrere aktive Lagen und Verdrahtungsebenen zu realisieren.

Die a-Si:H-Technologie ist vollkompatibel mit der in der Mikroelektronik zur Herstellung integrierter Schaltkreises verwendeten Technologie. Dadurch ist es möglich, Teile eines neuronalen Netzes in amorphem, wasserstoffhaltigem Silizium z. B. auf einem kristallinen Speicherchip aufzubauen.

In Dünnfilmtechnologie herstellbare Photoelemente sind aufgrund ihrer Eigenschaften als Synapsen geeignet. Photoelemente haben bei unterschiedlicher Beleuchtung unterschiedliche Widerstände. Der elektrische Widerstand eines Photoelements läßt sich durch entsprechende Beleuchtung stufenlos einstellen. Photoelemente sind in großer Zahl gleichmäßig herstellbar.

Die Verwendung einer Photoelementanordnung als Synapsenmatrix ist z. B. aus C. D. Kornfeld et al., IEEE International Conference on Neural Networks, San Diego, California (1988), S. II-357 - II-364, bekannt. In Zeilen und Spalten sind Photoelemente aufgebaut, über die an den jeweiligen Zeilen- und Spaltenenden angeschlossene, in konventioneller Elektronik aufgebaute Neuronen verbunden sind. Die Programmierung der aus den Photoelementen gebildeten Synapsen erfolgt optisch. Die Synapsenmatrix wird über eine Lochblendenmaske oder eine Art Dia oder durch einen Videoprojektor beleuchtet. Die Beleuchtung stellt während des Betriebs des neuronalen Netzwerkes das Programm dar, in dem die Information in Form der unterschiedlich starken Verbindungen gespeichert ist.

Die optische Programmierung von Synapsenmatrizen aus Photoelementen hat den Nachteil, daß bei der optischen Abbildung aufgrund der vielfältigen Abbildungsfehler und des erforderlichen mechanischen Aufbaus Toleranzen auftreten. Bei der Verwendung eines Videoprojektors zur Beleuchtung z. B. sind weder die Helligkeit noch die Bildgeometrie wirklich stabil. Außerdem läßt die Bildqualität selbst zu wünschen übrig. Bei der Verwendung einer Lochblendenmaske oder eines Dias zur Beleuchtung sind die Möglichkeiten zur Veränderung der Beleuchtung, wie sie dem Anpassen von Verbindungsstärken im Lernprozeß entsprechen, sehr eingeschränkt. Im übrigen ist ein stabiler mechanischer Aufbau in Form einer optischen Bank erforderlich.

Der Erfindung liegt die Aufgabe zugrunde, ein neuronales Netzwerk mit optischer Programmierung anzugeben, bei dem die Toleranzen aufgrund von Abbildungs- und Beleuchtungsfehlern unterdrückt werden und bei dem eine Anpassung an veränderte Verbindungsstärken gewährleistet ist.

Die Aufgabe wird erfindungsgemäß gelöst durch ein neuronales Netzwerk mit optischer Programmierung nach Anspruch 1.

Durch Integration der Einrichtung zur optischen Programmierung mit der aus Photoelementen bestehenden Synapsenmatrix auf einem Substrat weist das erfindungsgemäße neuronale Netzwerk eine gute Stabilität der optischen Programmierung auf. Abbildungsfehler werden durch die feste Anordnung minimiert. Wenn die Neuronen ebenfalls auf dem Substrat integriert enthalten sind, ist das neuronale Netzwerk einfach herstellbar. Aufwendiges Anbonsen von in anderer Technologie hergestellte Neuronen an die Synapsenmatrix entfällt.

Als Einrichtung zur optischen Programmierung wird erfindungsgemäß ein Lichtmodulator verwendet. Es liegt im Rahmen der Erfindung als Lichtmodulator eine Anordnung mit einem Flüssigkristall nach Art eines Flüssigkristallbildschirms zu verwenden. Herkömmliche Flüssigkristallbildschirm verwenden Flüssigkristalle mit Schraubenstruktur. Diese Anzeigenart ist unter der Bezeichnung verdrillt nematische Zelle bzw. Twisted Nematic (TN) Zelle geläufig. Die Möglichkeiten für den Multiplexbetrieb einer solchen Flüssigkristallmatrix sind begrenzt, daher enthalten anspruchsvollere Flüssigkristallbildschirme eine aktive Matrixansteuerung aus Dünnfilmtransistoren aus amorphem, wasserstoffhaltigem Silizium. Da Flüssigkristallbildschirme überdies flach herstellbar sind, bietet sich die Integration auf einem gemeinsamen Substrat mit der aus Photoelementen bestehenden Synapsenmatrix an. Über die aktive Matrixansteuerung können die Verbindungsstärken der Synapsen während des Betriebs des neuronalen Netzwerkes nach den Lernvorgängen angepaßt werden.

Wegen ihrer Speichereigenschaften und sehr kurzen Schaltzeit ist der Einsatz feroelektrischer Flüssigkristalle, die zur Zeit entwickelt werden, besonders vorteilhaft.

Andere physikalische Effekte zur Lichtmodulation, wie z. B. der elektrooptische Kerreffekt, sind in analoger Weise nutzbar.

Eine weitere Ausführungsform der Erfindung besteht darin, als Einrichtung zur optischen Programmierung eine Lichtquellenanordnung vorzusehen. Dabei liegt es im Rahmen der Erfindung als Lichtquellen Elektrolumineszenzelemente zu verwenden, welche durch Dünnfilmtransistoren angesteuert werden.

Das neuronale Netzwerk ist als Speicher verwendbar, wenn zwischen der Synapsenmatrix und der Einrichtung zur optischen Programmierung eine Maske mit einem festen Muster angeordnet ist.

Weitere Ausgestaltungen der Erfindung gehen aus den übrigen Ansprüchen hervor.

Das erfindungsgemäße neuronale Netzwerk hat den Vorteil, daß Abbildungsoptiken und damit verbundene Abbildungsfehler sowie die dazu erforderlichen mechanischen Komponenten wegfallen. Zwischen der Einrichtung zur optischen Programmierung und dem Photoelement besteht eine strenge geometrische Zuordnung. Diese wird im Herstellvorgang festgelegt. Daher entfallen Justier- und Dejustierprobleme und damit verbundene Probleme durch mechanische Erschütterungen, Erwärmung und ähnliches.

Das Konzept für das erfindungsgemäße neuronale Netzwerk basiert auf bereits erarbeitetem Bildsensor- und Bildschirm-Know-how. Daher erscheint es realistisch, selbst mit Labormitteln Netze mit bis zu 10⁵ Verbindungen herzustellen.

Im weiteren wird die Erfindung anhand der Figuren näher erläutert.

Fig. 1 zeigt ein Ersatzschaltbild für ein neuronales Netzwerk mit optischer Programmierung.
In Fig. 2 ist ein Querschnitt durch ein erfindungsgemäßes neuronales Netz mit integrierter optischer Programmierung vorgestellt.
In Fig. 3 ist ein Schaltbild für ein Neuron dargestellt.
In Fig. 4 ist der schematische Aufbau in Dünnschichttechnologie für ein Neuron gemäß der in Fig. 3 dargestellten Schaltung gezeigt.

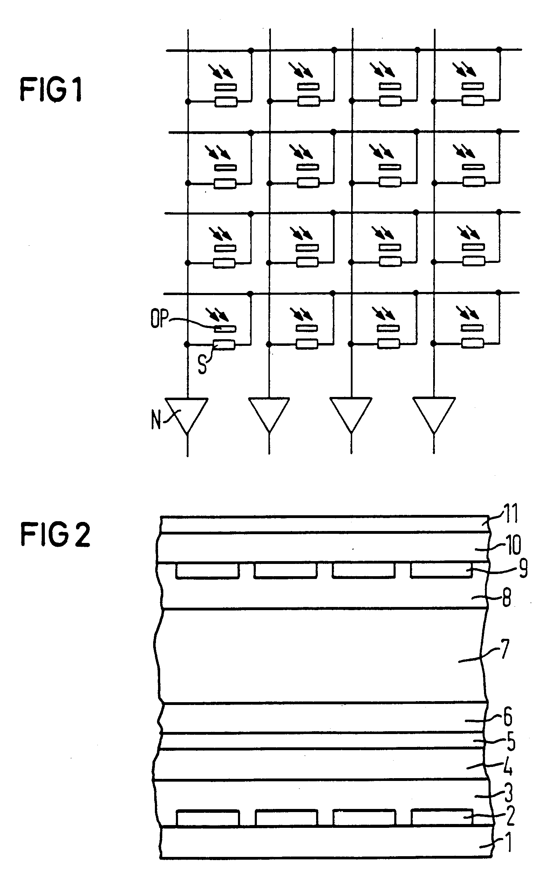

In Fig. 1 ist ein Ausschnitt aus einem neuronalen Netzwerk dargestellt, der das Prinzip der optischen Programmierung zeigt. Der Ausschnitt enthält Synapsen S, die matrixförmig angeordnet sind und Neuronen N, die jeweils mit einer Spalte der Matrix verbunden sind. Die Synapsen bestehen aus Photoelementen, die über Einrichtungen zur optischen Programmierung OP beleuchtbar sind. Dabei ist jede Synapse S individuell beleuchtbar. Entsprechend der Beleuchtung weisen die Synapsen S unterschiedliche elektrische Widerstände auf bzw. es fließt ein unterschiedlich großer Strom durch sie. Als Einrichtung zur optischen Programmierung OP sind z. B. Lichtmodulatoren oder Lichtquellenanordnungen geeignet. Zur Lichtmodulation sind z. B. Anordnungen unter Verwendung von Flüssigkristallen nach Art eines Flüssigkristallbildschirms oder z. B. Anordnungen, die den elektrooptischen Kerreffekt ausnutzen geeignet. Als Lichtquellenanordnungen sind z. B. von Dünnfilmtransistoren angesteuerte Elektrolumineszenzelemente geeignet.

In Fig. 2 ist ein Substrat 1 aus z. B. Glas dargestellt. Auf dem Substrat 1 ist eine erste Elektrodenstruktur 2 angeordnet. Die erste Elektrodenstruktur 2 besteht z. B. aus Chrom oder Titan. Die erste Elektrodenstruktur 2 ist mit einer photoleitenden Schicht 3 bedeckt. Die photoleitende Schicht 3 besteht z. B. aus amorphem, wasserstoffhaltigem Silizium und weist eine Dicke von etwa 1µm auf. Auf der photoleitenden Schicht 3 ist eine transparente, elektrisch leitende Schicht 4 angeordnet. Die transparente, elektrisch leitende Schicht 4 besteht z. B. aus Indiumzinnoxid und weist eine Dicke von etwa 100 nm auf. Das Substrat 1, die erste Elektrodenstruktur 2, die photoleitende Schicht 3 und die transparente, elektrisch leitende Schicht 4 bilden eine Synapsenmatrix, wobei die Synapsen durch Photoelemente gebildet werden. Die flächenmäßige Ausdehnung jedes Photoelements wird durch die erste Elektrodenstruktur 2 definiert.

Auf der transparenten, elektrisch leitenden Schicht 4 ist eine erste Polarisatorschicht 5 angeordnet. Die erste Polarisatorschicht besteht z. B. aus einem dielektrischen Polarisator und weist eine Dicke von etwa 100 nm auf. Auf der ersten Polarisatorschicht 5 ist eine erste Polyimidschicht 6 mit einer Dicke von etwa 100 nm angeordnet. Auf der ersten Polyimidschicht 6 ist ein Flüssigkristall 7 angeordnet. Als Flüssigkristall 7 sind z. B. folgende Materialien geeignet: Twisted oder super-twisted nematische Flüssigkristalle. Polarisatoren sind nicht erforderlich, wenn man ein Flüssigkristall-Material für eine Streuzelle verwendet. Der Flüssigkristall 7 hat typischerweise eine Dicke von 5 µm - 10 µm. Auf dem Flüssigkristall 7 ist eine zweite Polyimidschicht 8 in einer Dicke von etwa 100 nm angeordnet. Auf der zweiten Polyimidschicht 8 ist eine zweite Elektrodenstruktur 9 angeordnet. Die zweite Elektrodenstruktur 9 besteht aus transparentem, elektrisch leitfähigem Material, z. B. Indiumzinnoxid (ITO). Die erste Elektrodenstruktur 2 und die zweite Elektrodenstrukur 9 sind mindestens im Bereich der Synapsenmatrix deckungsgleich und entsprechend übereinander angeordnet. Mit Hilfe der zweiten Elektrodenstruktur 9 werden die Flüssigkristalle im Flüssigkristall 7 ausgerichtet. Die erste Elektrodenstruktur 2 definiert die Flächenbereiche der einzelnen Photoelemente. Auf der zweiten Elektrodenstruktur 9 ist eine Glasschicht 10 in einer Dicke von etwa 1 mm angeordnet. Auf der Glasschicht 10 ist eine zweite Polarisatorschicht 11 angeordnet, die z. B. aus einer Kunststoffolie besteht und eine Dicke von etwa 0,5 mm hat.

Die erste Polarisatorschicht 5, die erste Polyimidschicht 6, der Flüssigkristall 7, die zweite Polyimidschicht 8, die zweite Elektrodenstruktur 9, die Glasschicht 10 und die zweite Polarisatorschicht 11 bilden einen Flüssigkristallbildschirm. Der Flüssigkristallbildschirm wird zur Lichtmodulation bei der Beleuchtung der Synapsenmatrix verwendet. Licht wird dabei von der zweiten Polarisatorschicht 11 aus in die Anordnung eingestrahlt. Mit Hilfe der zweiten Elektrodenstruktur 9 werden die Flüssigkristallelemente des Flüssigkristalls 7 ausgerichtet. Da die zweiten Elektrodenstruktur 9 deckungsgleich über der ersten Elektrodenstruktur 2 angeordnet ist, werden die Flüssigkristallelemente oberhalb eines Photoelements gemeinsam ausgerichtet. Diese Anordnung der ersten Elektrodenstruktur 2 der zweiten Elektrodenstruktur 9 stellt daher sicher, daß die Beleuchtung jedes Photoelementes individuell lichtmoduliert wird.

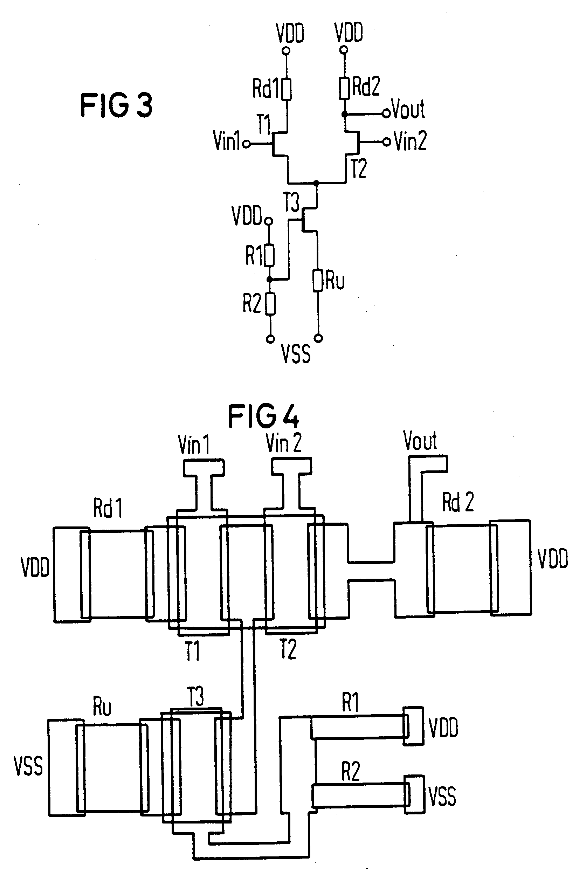

In Fig. 3 ist eine Schaltung für ein Neuron dargestellt, das abhängig von zwei Eingangssignalen Vin1 und Vin2 ein Ausgangssignal Vout erzeugt. In der Schaltung ist ein erster Transistor T1 vorgesehen, an dessen Steueranschluß das erste Eingangssignal Vin1 anliegt. Ein erster Anschluß des ersten Transistors T1 ist über einen ersten Widerstand Rd1 mit einer ersten Versorgungsspannung VDD verbunden. Es ist ein zweiter Transistor T2 vorgesehen, an dessen Steuerelektrode das zweite Eingangssignal Vin2 anliegt. Ein erster Anschluß des zweiten Transistors T2 ist über einen zweiten Widerstand Rd2 mit der ersten Versorgungsspannung VDD verbunden. An dem ersten Anschluß des zweiten Transistors T2 wird das Ausgangssignal Vout abgegriffen. Ein zweiter Anschluß des ersten Transistors und ein zweiter Anschluß des zweiten Transistors T2 sind miteinander und mit einem ersten Anschluß eines dritten Transistors T3 verbunden. Die Steuerelektrode des dritten Transistors T3 ist über einen dritten Widerstand R1 mit der ersten Versorgungsspannung VDD verbunden. Die Steuerelektrode des dritten Transistors T3 ist ferner über einen vierten Widerstand R2 mit einer zweiten Versorgungsspannung VSS verbunden. Ein zweiter Anschluß des dritten Transistors T3 ist über einen fünften Widerstand RU mit der zweiten Versorgungsspannung VSS verbunden.

Die Schaltung bewirkt eine Subtraktion der Eingangssignale Vin1 und Vin2. Sie erzeugt das Ausgangssignal Vout nach einer Schwellwertlogik.

In Fig. 4 ist schematisch eine Realisierung in Dünnfilmtechnik der in Fig. 3 gezeigten Schaltung dargestellt. Neuronen entsprechend dieser Schaltung werden in dem erfindungsgemäßen neuronalen Netz verwendet. Dabei werden die Eingangssignale Vin1 und Vin2 an Zeilen der Synapsenmatrix angeschlossen. Das Ausgangssignal Vout wird wiederum mit der Synapsenmatrix verbunden.

In dem erfindungsgemäßen neuronalen Netzwerk sind auf einem Substrat integriert sowohl die Synapsenmatrix als auch die Einrichtung zur optischen Programmierung und die Neuronen. Dies ist möglich, da alle drei Bestandteile in derselben Technologie herstellbar sind.

## Patentansprüche

1. Neuronales Netzwerk mit optisch Programmierung mit folgenden Merkmalen:
a) es ist ein Substrat (1) vorgesehen, das integriert eine Synapsenmatrix (S) und eine Einrichtung zur optischen Programmierung (OP) enthält,
b) die Einrichtung zur optischen Programmierung (OP) umfaßt individuell ansteuerbare, jeweils einer Synapse fest zugeordnete Lichtelemente,
c) die Synapsen (S) bestehen aus Photoelementen, die mit Hilfe der Einrichtung zur optischen Programmierung (OP) jeweils individuell beleuchtbar sind,
d) die Synapsen (S) weisen unterschiedliche, durch Beleuchtung mit Hilfe der Einrichtung zur optischen Programmierung (OP) stufenlos einstellbare elektrische Widerstände auf,
e) es sind Neuronen (N) vorgesehen, die über Synapsen (S) miteinander verbunden sind,
f) mindestens die Synapsenmatrix (S) und die Einrichtung zur optischen Programmierung (OP) sind in Dünnfilmtechnologie realisiert.

2. Neuronales Netzwerk nach Anspruch 1,
**dadurch gekennzeichnet,** daß die Neuronen (N) in Dünnfilmtechnologie im Substrat (1) integriert sind.

3. Neuronales Netzwerk nach Anspruch 1 oder 2
**dadurch gekennzeichnet,** daß als Einrichtung zur optischen Programmierung (OP) ein Lichtmodulator vorgesehen ist.

4. Neuronales Netzwerk nach Anspruch 3,
**dadurch gekennzeichnet,** daß als Einrichtung zur optischen Programmierung (OP) eine Anordnung unter Verwendung von Flüssigkristallen nach Art eines Flüssigkristallbildschirms vorgesehen ist.

5. Neuronales Netzwerk nach Anspruch 4,
**gekennzeichnet durch** folgende Merkmale:
a) auf dem Substrat (1) ist eine erste Elektrodenstruktur (2) angeordnet,
b) die erste Elektrodenstruktur (2) ist mit einer photoleitenden Schicht (3) bedeckt,
c) auf der photoleitenden Schicht (3) ist eine transparente, elektrisch leitende Schicht (4) angeordnet,
d) auf der transparenten, elektrisch leitenden Schicht (4) ist eine erste Polarisatorschicht (5) angeordnet,
e) auf der ersten Polarisatorschicht (5) ist eine erste Polyimidschicht (6) angeordnet,
f) auf der ersten Polyimidschicht (6) ist eine Flüssigkristallschicht (7) angeordnet,
g) auf der Flüssigkristallschicht (7) ist eine zweite Polyimidschicht (8) angeordnet,
h) auf der zweiten Polyimidschicht (8) ist eine zweite Elektrodenstruktur (9) aus transparentem, elektrisch leitfähigem Material angeordnet,
i) auf der zweiten Elektrodenstruktur (9) ist eine Glasschicht (10) angeordnet,
j) auf der Glasschicht (10) ist eine zweite Polarisatorschicht (11) angeordnet,
k) die erste Elektrodenstruktur (2) und die zweite Elektrodenstruktur (9) sind mindestens im Bereich der Synapsenmatrix deckungsgleich und entsprechend übereinander angeordnet.

6. Neuronales Netzwerk nach Anspruch 5,
**dadurch gekennzeichnet,** daß das Substrat (1) aus Glas, die ersten Elektrodenstruktur (2) aus Chrom oder Titan, die photoleitende Schicht (3) aus amorphem, wasserstoffhaltigem Silizium, die transparente, elektrisch leitende Schicht (4) aus Indiumzinnoxid (ITO), die erste Polarisatorschicht (5) aus einem dielektrischen Polarisator, die Flüssigkristallschicht (7) aus einem twisted oder super-twisted nematischen oder einem feroelektrischen Flüssigkristall,die zweite Elektrodenstruktur (9) aus Indiumzinnoxid (ITO) und die zweite Polarisatorschicht (11) aus Kunststofffolie bestehen.

7. Neuronales Netzwerk nach Anspruch 3,
**dadurch gekennzeichnet,** daß als Einrichtung zur optischen Programmierung (OP) eine Lichtquellenanordnung vorgesehen ist.

8. Neuronales Netzwerk nach Anspruch 7,
**dadurch gekennzeichnet,** daß als Einrichtung zur optischen Programmierung (OP) eine Elektrolumineszenzdiodenanordnung vorgesehen ist, wobei die Elektrolumineszenzdioden von im Substrat integrierten Dünnfilmtransistoren angesteuert werden.

9. Neuronales Netzwerk nach einem der Ansprüche 1 bis 8,
**dadurch gekennzeichnet,** daß eine Maske mit einem festen Muster vorgesehen ist, die zwischen der Synapsenmatrix (S) und der Einrichtung zur optischen Programmierung (OP) angeordnet ist.

## Claims

1. Neuron network with optical programming, having the following features:
a) a substrate (1) is provided which contains integrated a synapse matrix (S) and a device for optical programming (OP),
b) the device for optical programming (OP) consists of photoelectric elements which can be triggered individually and are in each case permanently assigned to a synapse,
c) the synapses (S) consist of photoelectric elements which can be in each case individually illuminated with the aid of the device for optical programming (OP),
d) the synapses (S) have different electrical resistances which can be continuously adjusted by illumination with the aid of the device for optical programming (OP),
e) neurons (N) which are connected to one another via synapses (S) are provided,
f) at least the synapse matrix (S) and the device for optical programming (OP) are implemented in thin-film technology.

2. Neuron network according to Claim 1, characterized in that the neurons (N) are integrated in the substrate (1) in thin-film technology.

3. Neuron network according to Claim 1 or 2, characterized in that a light modulator is provided as device for optical programming (OP).

4. Neuron network according to Claim 3, characterized in that an arrangement using liquid crystals in the manner of a liquid crystal screen is provided as device for optical programming (OP).

5. Neuron network according to Claim 4, characterized by the following features:
a) a first electrode structure (2) is arranged on the substrate (1),
b) the first electrode structure (2) is covered with a photoconductive layer (3),
c) a transparent electrically conductive layer (4) is arranged on the photoconductive layer (3),
d) a first polarizer layer (5) is arranged on the transparent electrically conductive layer (4),
e) a first polyimide layer (6) is arranged on the first polarizer layer (5),
f) a liquid crystal layer (7) is arranged on the first polyimide layer (6),
g) a second polyimide layer (8) is arranged on the liquid crystal layer (7),
h) a second electrode structure (9) of transparent electrically conductive material is arranged on the second polyimide layer (8),
i) a glass layer (10) is arranged on the second electrode structure (9),
j) a second polarizer layer (11) is arranged on the glass layer (10),
k) the first electrode structure (2) and the second electrode structure (9) are coincident with one another at least in the area of the synapse matrix and are correspondingly arranged above one another.

6. Neuron network according to Claim 5, characterized in that the substrate (1) consists of glass, the first electrode structure (2) of chromium or titanium, the photoconductive layer (3) of amorphous, hydrogen-containing silicon, the transparent, electrically conductive layer (4) of indium tin oxide (ITO), the first polarizer layer (5) of a dielectric polarizer, the liquid crystal layer (7) of a twisted or super-twisted nematic or of a ferroelectric liquid crystal, the second electrode structure (9) of indium tin oxide (ITO) and the second polarizer layer (11) of plastic film.

7. Neuron network according to Claim 3, characterized in that a light source arrangement is provided as the device for optical programming (OP).

8. Neuron network according to Claim 7, characterized in that an electroluminescent diode arrangement is provided as device for optical programming (OP), the electroluminescent diodes being driven by thin-film transistors integrated in the substrate.

9. Neuron network according to one of Claims 1 to 8, characterized in that a mask with a fixed pattern is provided which is arranged between the synapse matrix (S) and the device for optical programming (OP).

## Revendications

1. Réseau neuronique à programmation optique présentant les caractéristiques suivantes :
a) il est prévu un substrat (1), qui contient, à l'état intégré, une matrice de synapses (S) et un dispositif de programmation optique (OP),
b) le dispositif de programmation optique (OP) comprend des éléments lumineux pouvant être commandés individuellement et associés de façon fixe respectivement à une synapse,
c) les synapses (S) sont constituées d'éléments photovoltaïques, qui peuvent être éclairés respectivement individuellement au moyen du dispositif de programmation optique (OP),
d) les synapses (S) ont des résistances électriques différentes, qui sont réglables progressivement par éclairement à l'aide du dispositif de programmation optique (OP),
e) il est prévu des neurones (N), qui sont reliés entre eux par l'intermédiaire de synapses (S),
f) au moins la matrice de synapses (S) et le dispositif de programmation (OP) sont réalisés selon la technique des couches minces.

2. Réseau neuronique suivant la revendication 1, caractérisé par le fait que les neurones (N) sont intégrés au substrat (1), selon la technologie des couches minces.

3. Réseau neuronique suivant la revendication 1 ou 2, caractérisé en ce qu'un modulateur de lumière est prévu en tant que dispositif de programmation optique (OP).

4. Réseau neuronique suivant la revendication 3, caractérisé en ce que comme dispositif de programmation optique (OP), il est prévu un dispositif utilisant des cristaux liquides à la manière d'un écran à cristaux liquides.

5. Réseau neuronique suivant la revendication 4, caractérisé par les caractéristiques suivantes :
a) une première structure d'électrodes (2) est disposée sur le substrat (1),
b) la première structure d'électrodes (2) est recouverte d'une couche photoconductrice (3),
c) une couche transparente électriquement conductrice (4) est disposée sur la couche photoconductrice (3),
d) une première couche de polarisation (5) est disposée sur la couche transparente électriquement conductrice (4),
e) une première couche de polyimide (6) est disposée sur la première couche de polarisation (5),
f) une couche de cristal liquide (7) est disposée sur la première couche de polyimide (6),
g) une seconde couche de polyimide (8) est disposée sur la couche de cristal liquide (7),
h) une seconde structure d'électrodes (9) en un matériau transparent et électriquement conducteur est disposée sur la seconde couche de polyimide (8),
i) une couche de verre (10) est disposée sur la seconde structure d'électrodes (9),
j) une seconde couche de polarisation (11) est disposée sur la couche de verre (10),
k) la première structure d'électrodes (2) et la seconde structure d'électrodes (9) sont disposées en recouvrement et de façon correspondante en superposition, au moins dans la zone de la matrice de synapes.

6. Réseau neuronique suivant la revendication 5, caractérisé par le fait que le substrat (1) est en verre, que la première structure d'électrodes (2) est en chrome ou en titane, que la couche photoconductrice (3) est réalisée en silicium amorphe contenant l'hydrogène, que la couche transparente électriquement conductrice (4) est en oxyde d'indium et d'étain (ITO), que la première couche de polarisation (5) est formée d'un polariseur diélectrique, que la couche de cristal liquide (7) est constituée d'un cristal liquide nématique torsadé ou supertorsadé ou d'un cristal liquide ferroélectrique, que la seconde structure d'électrodes (9) est en oxyde d'indium et d'étain (ITO) et que la seconde couche de polarisation (11) est formée d'une feuille de matière plastique.

7. Réseau neuronique suivant la revendication 3, caractérisé par le fait qu'un ensemble de sources de lumière est prévu en tant que dispositif de programmation optique (OP).

8. Réseau neuronique suivant la revendication 7, caractérisé par le fait qu'il est prévu comme dispositif de programmation optique (OP) un dispositif à diodes électroluminescentes, les diodes électroluminescentes étant commandées par des transistors à couches minces, intégrés dans le substrat.

9. Réseau neuronique suivant l'une des revendications 1 à 8, caractérisé par le fait qu'il est prévu un masque de configuration fixe, qui est interposé entre la matrice de synapses (S) et le dispositif de programmation optique (OP).
